# EUROPÄISCHE PATENTSCHRIFT

(11) **EP 2 788 527 B1**
(45) Veröffentlichungstag und Bekanntmachung des Hinweises auf die Patenterteilung: **24.03.2021**
(21) Anmeldenummer: 12810118.5
(22) Anmeldetag: 28.11.2012
(51) Int. Cl.: C23C 16/36, C23C 28/04, C04B 41/00, C04B 41/87, C04B 41/50, C04B 111/00

(54) **HARTSTOFFBESCHICHTETE KÖRPER AUS METALL, HARTMETALL, CERMET ODER KERAMIK SOWIE VERFAHREN ZUR HERSTELLUNG DERARTIGER KÖRPER**
HARD-MATERIAL-COATED BODIES COMPOSED OF METAL, CEMENTED HARD MATERIAL, CERMET OR CERAMIC AND PROCESSES FOR PRODUCING SUCH BODIES
CORPS EN MÉTAL, EN MÉTAL DUR, EN CERMET OU EN CÉRAMIQUE REVÊTUS D'UNE SUBSTANCE DURE ET PROCÉDÉ DE FABRICATION DE CORPS DE CE TYPE

(30) Priorität: 05.12.2011 DE 102011087715
(43) Veröffentlichungstag der Anmeldung: 15.10.2014
(73) Patentinhaber: Fraunhofer Gesellschaft zur Förderung der angewandten Forschung e.V., 80686 München (DE)
(72) Erfinder: ENDLER, Ingolf, 01640 Coswig (DE); SCHOLZ, Sebastian, 01219 Dresden (DE)
(74) Vertreter: Rauschenbach, Dieter
(86) Internationale Anmeldenummer: PCT/EP2012/073766
(87) Internationale Veröffentlichungsnummer: WO 2013/083447

(56) Entgegenhaltungen:
- WO-A1-97/07260
- DE-A1-102005 049 393
- DE-C1- 3 811 907
- JP-A- H10 280 148
- US-A1- 2010 215 951
- MA ET AL: "Synthesis and characterization of super hard, self-lubricating Ti-Si-C-N nanocomposite coatings", ACTA MATERIALIA, ELSEVIER, OXFORD, GB, Bd. 55, Nr. 18, 10. Oktober 2007 (2007-10-10), Seiten 6350-6355, XP022294961, ISSN: 1359-6454, DOI: 10.1016/J.ACTAMAT.2007.07.046
- WEI ET AL: "Plasma enhanced magnetron sputter deposition of Ti-Si-C-N based nanocomposite coatings", SURFACE AND COATINGS TECHNOLOGY, ELSEVIER, AMSTERDAM, NL, Bd. 203, Nr. 5-7, 25. Dezember 2008 (2008-12-25), Seiten 538-544, XP025656869, ISSN: 0257-8972, DOI: 10.1016/J.SURFCOAT.2008.05.019 [gefunden am 2008-05-22]
- KUO D-H ET AL: "A new class of Ti-Si-C-N coatings obtained by chemical vapor deposition, Part II: low-temperature process", THIN SOLID FILMS, ELSEVIER-SEQUOIA S.A. LAUSANNE, CH, Bd. 419, Nr. 1-2, 1. November 2002 (2002-11-01), Seiten 81-89, XP05505550,

## Beschreibung

### TECHNISCHES GEBIET

Die Erfindung betrifft hartstoffbeschichtete Körper aus Metall, Hartmetall, Cermet oder Keramik, beschichtet mit einer TiSiCN-Schicht oder einem Schichtsystem, das mindestens eine TiSiCN-Schicht enthält, sowie ein Verfahren zur Herstellung derartiger Körper. Die auf den Körpern erzeugte erfindungsgemäße Hartstoffschicht zeichnet sich durch eine hohe Härte, hohe Oxidations- und Temperaturbeständigkeit sowie eine hohe Haftfestigkeit aus und ist als Verschleißschutzschicht auf vielen Hartmetall- und Keramikwerkzeugen einsetzbar.

### STAND DER TECHNIK

Viele Hartmetall- und Keramikwerkzeuge weisen heute Verschleißschutzbeschichtungen auf, die die Standzeit entscheidend erhöhen. Durch ihre besonderen Eigenschaften, wie z.B. hohe Härte, gute Oxidations- und Temperaturbeständigkeit, wird das Werkzeug geschützt und die Leistungsfähigkeit deutlich erhöht.

So sind unter anderem Ti-basierte Hartstoffschichten, wie TiN und TiCN, bekannt. Derartige Hartstoffschichten weisen jedoch eine unzureichende Oxidationsbeständigkeit auf, so dass diese bei der Zerspanung aufgrund der hohen Temperaturen an der Schneidkante nicht ohne Kühlschmierstoff eingesetzt werden können.

Die Oxidationsbeständigkeit und die Härte dieser Schichten kann durch den Einbau weiterer Elemente wie Aluminium oder Silicium verbessert werden. Ein Weg ist die Entwicklung von siliciumhaltigen Nanokompositschichten, die aus einer nanokristallinen TiCN-Phase und einer amorphen siliciumhaltigen Phase bestehen.

Komposite oder Nanokomposite des Systems Ti-Si-C-N können bereits mit verschiedenen physikalischen und plasmaunterstützten chemischen Gasphasenabscheidungsverfahren abgeschieden werden. Diese Schichten zeichnen sich durch eine hohe Härte und verringerte Reibwerte aus (siehe J.-H. Jeon, S.R. Choi, W.S. Chung, K.H. Kim, Surface & Coatings Technology 188-189 (2004) 415 und R. Wei, C. Rincon, E. Langa, Journal of Vacuum Science and Technology A 28 (2010) 1126).

In Ma et al.: "Synthesis and characterization of Ti-Si-C-N nanocomposite coatings", Acta Materialia, Elsevier, Oxford, G Bd. 55, Nr. 18, (2007) wird die Herstellung und Charakterisierung einer superfesten und selbstschmierenden Ti-Si-C-N Nanokompositschicht offenbart, die mittels plasmaunterstütztem CVD-Verfahren abgeschieden wird. Die Nanokompositschicht besteht aus einer nanokristallinen Ti(C,N)-Phase sowie zwei amorphen Phasen, nämlich einer amorphen Si₃N₄-Phase und einer amorphen C-Phase. In den offenbarten XPS-Spektren werden C-C-Bindungen und Si-N-Bindungen nachgewiesen, wobei die amorphe Phase aus einer amorphen Si₃N₄-Phase und aus einer amorphen C-Phase besteht, bei der Kohlenstoff ungebunden vorliegt.

Bei den PVD-Techniken werden Magnetronsputterverfahren oder Arc-Prozesse angewendet, wie in DE 3811907 C1, WO 2008/130316 A1 und von J.-H. Jeon, S.R. Choi, W.S. Chung, K.H. Kim, Surface & Coatings Technology 188-189 (2004) 415 beschrieben. Durch die Anwendung der plasmaunterstützten CVD (PECVD) können ebenfalls TiSiCN-Schichten mit oder ohne Nanokompositstruktur hergestellt werden (siehe D. Ma, S. Ma, H. Dong, K. Xu, T. Bell, Thin Solid Films 496 (2006) 438 und P. Jedrzeyowski, J.E, Klemberg-Sapieha, L. Martinu, Surface & Coatings Technology 188-189 (2004) 371). Die mittels PECVD hergestellten TiSiCN-Nanokompositschichten weisen ähnlich hohe Härten und Eigenschaften wie die PVD-Schichten auf.

Aus WEI et al.: Plasma enhanced magnetron sputter deposition of Ti-Si-C-N based nanocomposite coatings", Surface and coating technology, Elsevier, Amsterdam, Bd. 203, Nr. 5-7, (2008) ist eine mittels PEMS hergestellte Nanokompositschicht aus einer nanokristallinen TiCN-Phase und einer amorphen SiCxNy-Phase mit einem Si-Gehalt ≤ 3,5 At.-% und einem Kohlenstoffgehalt zwischen 10 und 20 At.-% bekannt. Die Schichten weisen Si-Gehalte von 2 bis 3,5 At.-% auf.

Bisher gab es nur wenige Versuche Hartstoffschichten im System Ti-Si-C-N mittels der thermischen chemischen Gasphasenabscheidung (CVD) herzustellen. Kuo et. al. haben in drei wissenschaftlichen Publikationen über ihre diesbezüglichen Untersuchungen berichtet (siehe D.-H. Kuo, K.-W. Huang, Thin Solid Films 394 (2001) 72 sowie D.-H. Kuo, K.-W. Huang, Thin Solid Films 394 (2001) 81 und D.-H. Kuo, W.-C. Liao, Thin Solid Films 419 (2002) 11). Sie konnten aber bei Temperaturen bis 800°C nur TiSiCN-Kompositschichten mit einem Kohlenstoffgehalt kleiner als 8 At.% herstellen. Bei der kristallinen Phase handelt es sich um TiN oder TiN_{0,3} aber nicht um TiCₓN₁₋ₓ. Bei Temperaturen zwischen 800 °C und 1100 °C wurden keine Kompositschichten, sondern einphasige (Ti,Si)(C,N)-Schichten mit Härten zwischen 10 GPa und 27,5 GPa erzeugt. Die Härte dieser Schichten ist also vergleichsweise gering, im Gegensatz zu den oben erwähnten superharten Nanokompositschichten, die mittels PVD- und PECVD-Verfahren hergestellt wurden.

Aus der US 2008/0261058 A1 ist auch bereits eine Schicht bekannt, die aus TiC, TiN oder Ti(C,N) und den Legierungselementen Si, Cr, V besteht. Die Schicht besteht entweder aus einer kristallinen Mischphase mit den Legierungselementen oder einer Kompositschicht aus zwei oder mehr Phasen. Dabei liegt eine Phase in Form von TiCN-Körnern im Mikrometerbereich vor und die andere Phase besteht aus Nitriden und Karbiden der Legierungselemente Si, Cr, V.

Und aus der WO 97/07260 A1 ist ein Verbundkörper, bestehend aus einem Hartmetall-, Cermet-, Stahl- oder Keramik-Substratkörper und mindestens einer Metallcarbonitrid-Hartstoffschicht bekannt, wobei das Metall der Metallcarbonitridschicht zwei oder mehrere Elemente der Gruppe Ti, Zr, Hf, V, Nb, Ta, Cr, Mo und W enthält und dass das Metallcarbonitrid durch ein CVD-Verfahren oder ein Plasma-aktiviertes CVD-Verfahren unter Bildung einer einphasigen Schicht abgeschieden worden ist. Die Hartstoffschicht enthält kein Silicium. Nachteilig bei der vorgestellten Kompositschicht ist, dass diese nur eine geringe Härte und eine unzureichende Oxidationsbeständigkeit aufweist.

### DARSTELLUNG DER ERFINDUNG

Der Erfindung liegt die Aufgabe zugrunde, für Körper aus Metall, Hartmetall, Cermet oder Keramik ein Schichtsystem zu entwickeln, das ein- oder mehrlagig ist und das mindestens eine TiSiCN-Hartstoffschicht enthält, die sich durch eine hohe Härte, eine hohe Oxidations- und Temperaturbeständigkeit sowie eine hohe Haftfestigkeit auszeichnet. Eingeschlossen in diese Aufgabe ist die Entwicklung eines Verfahrens, das auch unter industriellen Bedingungen kostengünstig eine Erzeugung derartiger Beschichtungen ermöglicht.

Diese Aufgabe wird mit den Merkmalen der Patentansprüche gelöst, wobei die Erfindung auch Kombinationen der einzelnen abhängigen Ansprüche im Sinne einer UND-Verknüpfung mit einschließt.

Gegenstand der Erfindung sind hartstoffbeschichtete Körper aus Metall, Hartmetall, Cermet oder Keramik, beschichtet mit einer TiSiCN-Kompositschicht oder mit einem mehrlagigen Schichtsystem, das mindestens eine TiSiCN-Kompositschicht enthält, wobei die TiSiCN-Kompositschicht erfindungsgemäß eine mittels thermischem CVD-Verfahren ohne zusätzliche Plasmaanregung hergestellte Nanokompositschicht ist, die eine nanokristalline Phase aus TiCₓN₁₋ₓ mit einer Kristallitgröße zwischen 5 nm und 150 nm und eine zweite Phase aus amorphem SiCₓN_{y} enthält.

Dabei sind die nanokristalline Phase aus TiCₓN₁₋ₓ mit einem Anteil von 60 Ma.% bis 99 Ma.% und die amorphe SiCₓN_{y}-Phase mit einem Anteil von 1 Ma.%. bis 40 Ma.% enthalten.

Die Zusammensetzung der nanokristallinen TiCₓN₁₋ₓ -Phase liegt im Bereich von 0,1 ≤ x ≤ 0,99 und die der amorphen SiCₓN_{y}-Phase im Bereich von 0,1 ≤ x ≤ 0,95 und 0,05 ≤ y ≤ 0,9.

Der Kohlenstoff-Gehalt der TiSiCN-Nanokompositschicht beträgt vorteilhaft mehr als 8 At.%.

Die TiSiCN-Nanokompositschicht kann erfindungsgemäß als weiteren Bestandteil bis zu 5 Ma.% amorphen Kohlenstoff enthalten.

Die erfindungsgemäße TiSiCN-Nanokompositschicht weist einen Halogengehalt < 1 At.% und einen Sauerstoffgehalt < 4 At.% auf.

Erfindungsgemäß kann die TiSiCN-Nanokompositschicht aus TiSiCN-Einzellagen mit unterschiedlichen Titan/Silicium-Verhältnissen bestehen und/oder einen Gradienten hinsichtlich des Silicium- und Titan-Gehaltes aufweisen.

Nach weiteren Merkmalen der Erfindung kann die TiSiCN-Nanokompositschicht in einem mehrlagigen Schichtsystem mit einer oder mehreren Deckschichten und/oder Anbindungsschichten zum Substratkörper kombiniert sein, wobei diese Schichten aus einem oder mehreren Nitriden, Carbiden, Carbonitriden, Oxynitriden, Oxycarbiden, Oxycarbonitriden, Oxiden von Ti, Hf, Zr, Cr und/oder Al oder aus Mischphasen mit diesen Elementen bestehen.

Der mittels thermischer CVD hergestellte erfindungsgemäße Verbund einer nanokristallinen Phase aus TiCₓN₁₋ₓ mit einer amorphen SiCₓN_{y}-Phase stellt eine neue Kombination dar. Durch die Kombination dieser beiden Phasen tritt ein Synergieeffekt ein, der zu unerwartet sehr guten Schichteigenschaften führt, nämlich zu einer hohen Haftfestigkeit, einer hohen Oxidations- und Temperaturbeständigkeit und einer hohen Härte von bis über 4000 HV[0.01].

Zur Herstellung der erfindungsgemäßen TiSiCN-Nanokompositschicht beinhaltet die Erfindung ein Verfahren, bei dem die Schicht in einer Gasmischung, die ein oder mehrere Titanhalogenide, SiCl₄ oder Si₂Cl₆, Wasserstoff, sowie Acetonitril als reaktive Verbindungen mit Kohlenstoff- und Stickstoffatomen und/oder Stickstoffverbindungen und/oder Kohlenwasserstoffen und/oder inerte Edelgase enthält, mit einem thermischen CVD-Prozess bei Temperaturen zwischen 700 °C und 1100 °C und bei Drücken zwischen 10 Pa und 101,3 kPa ohne zusätzliche Plasmaanregung abgeschieden wird, wobei das Molverhältnis der Titanhalogenide und der siliciumhaltigen Precursoren so gewählt wird, dass in der Gasmischung ein Atomverhältnis von Si zu Ti größer 1 vorliegt.

Ein Vorteil der erfindungsgemäßen Schichten gegenüber mittels PVD hergestellten Schichten ist die höhere Haftfestigkeit. Ein weiterer, erheblicher Vorteil bei der Nutzung ist die Einbeziehung dieser Schicht in komplexere, mehrlagige CVD-Schichtsysteme.

Gegenüber der im Stand der Technik erwähnten plasmagestützten CVD (PECVD) ist das thermische CVD-Verfahren ein einfacheres und in der Industrie etabliertes Verfahren. PECVD-Verfahren spielen in der Werkzeugbeschichtung außer für die Herstellung harter Kohlenstoffschichten keine Rolle. PECVD-Schichten erreichen auch nicht die hohen Haftfestigkeiten der mittels thermischer CVD hergestellten Schichten.

### BEISPIELE ZUR AUSÜHRUNG DER ERFINDUNG

Nachstehend ist die Erfindung an Ausführungsbeispielen und den zugehörigen Abbildungen näher erläutert. Die Abbildungen zeigen:
Abb. 1: das Röntgendiffraktogramm der mittels CVD hergestellten TiSiCN-Nanokompositschicht gemäß Ausführungsbeispiel 1,
Abb. 2: eine REM-Aufnahme des Querschliffs eines Schichtsystems aus zwei TiN-Schichten (C) und (B) und der TiSiCN-Nanokompositschicht (A) gemäß Ausführungsbeispiel 3.

### Beispiel 1

Auf WC/Co-Harmetallwendeschneidplatten, die mit einem 5 µm dicken TiN/TiCN/TiN-Schichtsystem vorbeschichtet sind, wird eine TiSiCN-Nanokompositschicht mittels des erfindungsgemäßen thermischen CVD-Verfahrens als Deckschicht abgeschieden.

Dazu wird für die Abscheidung der TiSiCN-Nanokompositschicht in einen horizontalen Heißwand-CVD-Reaktor mit einem Innendurchmesser von 75 mm eine Gasmischung von 4,2 ml/min TiCl₄, 20,4 ml/min SiCl₄, 7,9 ml/min Acetonitril (CH₃CN) und 2400 ml/min Wasserstoff bei 800 °C und 6 kPa eingeleitet.

Nach einer Beschichtungszeit von 120 min zeigt sich eine graue Beschichtung, welche eine Schichtdicke von 4,3 µm aufweist.

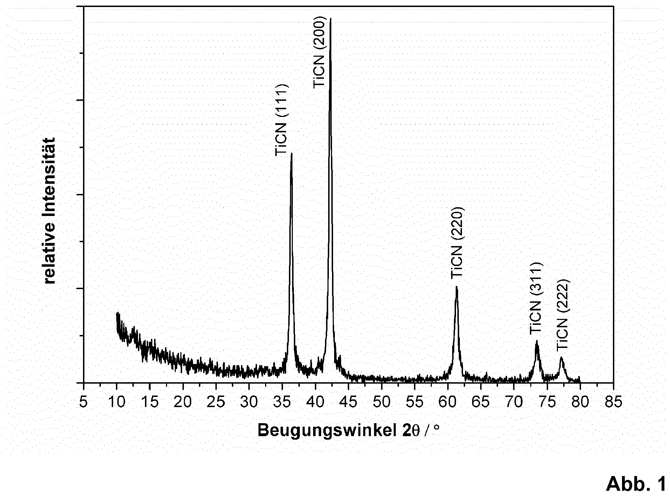

Bei der im streifenden Einfall durchgeführten röntgenographischen Dünnschichtanalyse wird nur das kristalline TiCₓN₁₋ₓ gefunden (siehe Röntgendiffraktogramm in Abb. 1). Silicium ist in einer zweiten, amorphen SiCₓN_{y}-Phase enthalten, analog der im Beispiel 3 durchgeführten XPS-Analyse. Die mittlere Korngröße der nanokristallinen Phase des TiCₓN₁₋ₓ wurde mittels Rietveld-Analyse auf 19 ± 0,4 nm bestimmt.

Die Elementanalyse mittels WDX ergab folgende Elementgehalte:
36,86 At.% Ti,
11,74 At.% Si,
27,39 At.% C,
20,82 At.% N,
0,39 At.% Cl und
2,80 At. % O.

Für diese TiSiCN-Nanokompositschicht wurde eine Mikrohärte von 4080 HV[0,01] gemessen.

### Beispiel 2

Auf einer mit 1 µm TiN und 3 µm TiCN vorbeschichteten WC/Co-Wendeschneidplatte wird zunächst eine weitere TiN-Schicht mit einer Dicke von 0,5 µm aufgebracht, gefolgt von der erfindungsgemäßen TiSiCN-Nanokompositschicht.

Dazu wird in den im Beispiel 1 genannten CVD-Reaktor eine Gasmischung aus 8,3 ml/min TiCl₄, 10 ml/min Si₂Cl₆, 10,6 ml/min CH₃CN und 2400 ml/min Wasserstoff bei 850 °C und 6 kPa eingeleitet. Nach einer Beschichtungszeit von 90 min wird eine graue Beschichtung erhalten, die eine Schichtdicke von 7,6 µm aufweist.

Bei der im streifenden Einfall durchgeführten röntgenographischen Dünnschichtanalyse wird ebenso wie beim Beispiel 1 nur das kristalline TiCₓN₁₋ₓ gefunden. Silicium ist in einer zweiten, amorphen SiCₓN_{y}-Phase enthalten, analog der im Beispiel 3 durchgeführten XPS-Analyse. Mittels Rietveld-Analyse wurde eine mittlere Korngröße für die nanokristallinen TiCₓN₁₋ₓ-Phase von 39 ± 2 nm erhalten.

Die WDX-Analyse ergab folgende Elementgehalte:
41,70 At.% Ti,
4,30 At. % Si,
28,07 At.% C,
23,15 At.% N,
0,01 At.% Cl und
2,77 At.% O.

Für diese TiSiCN-Nanokompositschicht wurde eine Mikrohärte von 3840 HV[0,01] gemessen.

### Beispiel 3

Auf einer mit 3 µm TiN vorbeschichteten WC/Co-Wendeschneidplatte wird zunächst eine weitere TiN-Schicht mit einer Dicke von 0,5 µm aufgebracht, gefolgt von der erfindungsgemäßen Nanokompositschicht aus TiSiCN.

Dazu wird in den im Beispiel 1 genannten CVD-Reaktor eine Gasmischung aus 4,2 ml/min TiCl₄, 10 ml/min Si₂Cl₆, 10,6 ml/min CH₃CN und 2400 ml/min Wasserstoff bei 850 °C und 6 kPa eingeleitet. Nach einer Beschichtungsdauer von 90 min wurde eine graue Beschichtung abgeschieden, welche eine Schichtdicke von 3,5 µm aufweist.

Bei der im streifenden Einfall durchgeführten röntgenographischen Dünnschichtanalyse wird ebenso wie in Beispiel 1 nur das kristalline TiCₓN₁₋ₓ gefunden. Eine kristalline siliciumhaltige Phase ist röntgenographisch nicht nachweisbar. Durch die XPS-Analyse der TiSiCN-Schicht wurden nach Auswertung des Si2p-Spektrums jedoch eindeutig Si-N-Bindungen bei 101,8 eV und Si-C-Bindungen bei 100,7 eV nachgewiesen, die das Vorhandensein einer amorphen SiCₓN_{y}-Phase anzeigen.

Die mittlere Korngröße der nanokristallinen Phase des TiCₓN₁₋ₓ wurde mittels Rietveld-Analyse bestimmt und ein Wert von 12 ± 4 nm erhalten. Die

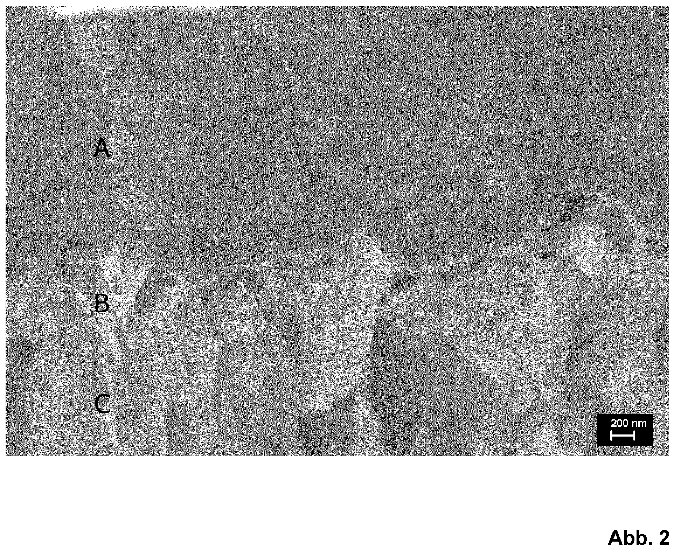

Nanokompositstruktur ist aus dem Querschliff in Abb. 2 ersichtlich. Die TiSiCN-Deckschicht (A) zeigt eine Nanokompositstruktur, bei der hellere nanokristalline TiCₓN₁₋ₓ-Kristallite in einer dunkleren amorphen Matrix eingebettet sind. Unterhalb der TiSiCN-Deckschicht sind die mikrokristallinen Anbindungsschichten TiN (C) und (B) zu sehen.

Die WDX-Analyse der TiSiCN-Deckschicht ergab folgende Elementgehalte:
32,75 At.% Ti,
12,72 At.% Si,
27,15 At.% C,
23,62 At.% N,
0,51 At.% Cl und
3,25 At. % O.

Für diese TiSiCN-Nanokompositschicht wurde eine Mikrohärte von 3610 HV[0,01] gemessen.

## Patentansprüche

1. Hartstoffbeschichtete Körper aus Metall, Hartmetall, Cermet oder Keramik, beschichtet mit einer TiSiCN-Kompositschicht oder mit einem mehrlagigen Schichtsystem, das mindestens eine TiSiCN-Kompositschicht enthält, **dadurch gekennzeichnet, dass** die TiSiCN-Kompositschicht eine mittels thermischem CVD-Verfahren ohne zusätzliche Plasmaanregung hergestellte Nanokompositschicht mit einem Halogengehalt < 1 At.% und einem Sauerstoffgehalt < 4 At.% ist, die eine nanokristalline Phase aus TiCₓN₁₋ₓ mit 0,1 ≤ x ≤ 0,99 mit einer Kristallitgröße zwischen 5 nm und 150 nm und eine zweite Phase aus amorphem SiCₓN_{y} mit 0,1 ≤ x ≤ 0,95 und 0,05 ≤ y ≤ 0,9 enthält.

2. Hartstoffbeschichtete Körper nach Anspruch 1, **dadurch gekennzeichnet, dass** die nanokristalline Phase aus TiCₓN₁₋ₓ mit einem Anteil von 60 Ma.% bis 99 Ma.% und die amorphe SiCₓN_{y}-Phase mit einem Anteil von 1 Ma.% bis 40 Ma.% enthalten sind.

3. Hartstoffbeschichtete Körper nach Anspruch 1, **dadurch gekennzeichnet, dass** der Kohlenstoff-Gehalt der TiSiCN-Kompositschicht mehr als 8 At.% beträgt.

4. Hartstoffbeschichtete Körper nach Anspruch 1, **dadurch gekennzeichnet, dass** die TiSiCN-Nanokompositschicht als weiteren Bestandteil bis zu 5 Ma.% amorphen Kohlenstoff enthält.

5. Hartstoffbeschichtete Körper nach Anspruch 1, **dadurch gekennzeichnet, dass** die TiSiCN-Nanokompositschicht aus TiSiCN-Einzellagen mit unterschiedlichen Titan/Silicium-Verhältnissen besteht.

6. Hartstoffbeschichtete Körper nach Anspruch 1, **dadurch gekennzeichnet, dass** die TiSiCN-Nanokompositschicht einen Gradienten hinsichtlich des Silicium- und Titan-Gehaltes aufweist.

7. Hartstoffbeschichtete Körper nach Anspruch 1, **dadurch gekennzeichnet, dass** die TiSiCN-Nanokompositschicht in einem mehrlagigen Schichtsystem mit einer oder mehreren Deckschichten und/oder Anbindungsschichten zum Substratkörper kombiniert ist, wobei diese Schichten aus einem oder mehreren Nitriden, Carbiden, Carbonitriden, Oxynitriden, Oxycarbiden, Oxycarbonitriden, Oxiden von Ti, Hf, Zr, Cr und/oder Al oder aus Mischphasen mit diesen Elementen bestehen.

8. Verfahren zur Herstellung hartstoffbeschichteter Körper aus Metall, Hartmetall, Cermet oder Keramik, beschichtet mit einer TiSiCN-Kompositschicht oder mit einem mehrlagigen Schichtsystem, das mindestens eine TiSiCN-Kompositschicht enthält, wobei die TiSiCN-Kompositschicht eine Nanokompositschicht mit einem Halogengehalt < 1 At.% und einem Sauerstoffgehalt < 4 At.% ist, die eine nanokristalline Phase aus TiCₓN₁₋ₓ mit 0,1 ≤ x ≤ 0,99 mit einer Kristallitgröße zwischen 5 nm und 150 nm und eine zweite Phase aus amorphem SiCₓN_{y} mit 0,1 ≤ x ≤ 0,95 und 0,05 ≤ y ≤ 0,9 enthält, nach Anspruch 1, **dadurch gekennzeichnet, dass** die TiSiCN-Nanokompositschicht in einer Gasmischung, die ein oder mehrere Titanhalogenide, SiCl₄ oder Si₂Cl₆, Wasserstoff sowie Acetonitril als reaktive Verbindung mit Kohlenstoff- und Stickstoffatomen enthält, mit einem thermischen CVD-Prozess bei Temperaturen zwischen 700 °C und 1100 °C und bei Drücken zwischen 10 Pa und 101,3 kPa ohne zusätzliche Plasmaanregung auf dem Körper abgeschieden wird, wobei das Molverhältnis der Titanhalogenide und der siliciumhaltigen Precursoren so gewählt wird, dass in der Gasmischung ein Atomverhältnis von Si zu Ti größer 1 vorliegt.

9. Verfahren nach Anspruch 8, **dadurch gekennzeichnet, dass** der Gasmischung zusätzlich Stickstoffverbindungen und/oder Kohlenwasserstoffe und/oder inerte Edelgase zugemischt werden.

10. Verfahren nach Anspruch 9, **dadurch gekennzeichnet, dass** als Stickstoffverbindungen N₂ und/oder NH₃ und als Kohlenwasserstoffe C₂H₄ und/oder C₂H₂ verwendet werden.

## Claims

1. Hard material-coated bodies composed of metal, cemented hard material, cermet or ceramic and coated with a TiSiCN composite layer or with a multilayer layer system containing at least one TiSiCN composite layer, **characterized in that** the TiSiCN composite layer is a nanocomposite layer which has been produced by means of a thermal CVD process without additional plasma enhancement and has a halogen content of < 1 at% and an oxygen content of < 4 at% and contains a nanocrystalline phase composed of TiCₓN₁₋ₓ where 0.1 ≤ x ≤ 0.99 having a crystalline size in the range from 5 nm to 150 nm and a second phase composed of amorphous SiCₓN_{y} where 0.1 ≤ x ≤ 0.95 and 0.05 ≤ y ≤ 0.9.

2. Hard material-coated bodies according to Claim 1, **characterized in that** the nanocrystalline phase composed of TiCₓN₁₋ₓ is present in a proportion of from 60% by mass to 99% by mass and the amorphous SiCₓN_{y} phase is present in a proportion of from 1% by mass to 40% by mass.

3. Hard material-coated bodies according to Claim 1, **characterized in that** the carbon content of the TiSiCN composite layer is more than 8 at%.

4. Hard material-coated bodies according to Claim 1, **characterized in that** the TiSiCN nanocomposite layer contains up to 5% by mass of amorphous carbon as further constituent.

5. Hard material-coated bodies according to Claim 1, **characterized in that** the TiSiCN nanocomposite layer consists of TiSiCN individual layers having different titanium/silicon ratios.

6. Hard material-coated bodies according to Claim 1, **characterized in that** the TiSiCN nanocomposite layer has a gradient in respect of the silicon content and titanium content.

7. Hard material-coated bodies according to Claim 1, **characterized in that** the TiSiCN nanocomposite layer is combined in a multilayer layer system with one or more covering layers and/or bonding layers to the substrate body, where these layers consist of one or more nitrides, carbides, carbonitrides, oxynitrides, oxycarbides, oxycarbonitrides, oxides of Ti, Hf, Zr, Cr and/or Al or of mixed phases comprising these elements.

8. Process for producing hard material-coated bodies composed of metal, cemented hard material, cermet or ceramic and coated with a TiSiCN composite layer or with a multilayer layer system containing at least one TiSiCN composite layer, where the TiSiCN composite layer is a nanocomposite layer which has a halogen content of < 1 at% and an oxygen content of < 4 at% and contains a nanocrystalline phase composed of TiCₓN₁₋ₓ where 0.1 ≤ x ≤ 0.99 having a crystalline size in the range from 5 nm to 150 nm and a second phase composed of amorphous SiCₓN_{y} where 0.1 ≤ x ≤ 0.95 and 0.05 ≤ y ≤ 0.9, according to Claim 1, **characterized in that** the TiSiCN nanocomposite layer is deposited on the body by means of a thermal CVD process in a gas mixture containing one or more titanium halides, SiCl₄ or Si₂Cl₆, hydrogen and acetonitrile as reactive compound containing carbon and nitrogen atoms at temperatures in the range from 700°C to 1100°C and pressures in the range from 10 Pa to 101.3 kPa without additional plasma enhancement, where the molar ratio of the titanium halides and the silicon-containing precursors is selected so that an atomic ratio of Si to Ti of greater than 1 is present in the gas mixture.

9. Process according to Claim 8, **characterized in that** nitrogen compounds and/or hydrocarbons and/or inert noble gases are additionally mixed into the gas mixture.

10. Process according to Claim 9, **characterized in that** N₂ and/or NH₃ are used as nitrogen compounds and C₂H₄ and/or C₂H₂ are used as hydrocarbons.

## Revendications

1. Corps revêtus d'une substance dure, composés de métal, de métal dur, de cermet ou de céramique, revêtus avec une couche de composite de TiSiCN ou avec un système de couches multicouche, qui contient au moins une couche de composite de TiSiCN, **caractérisé en ce que** la couche de composite de TiSiCN est une couche de nanocomposite préparée au moyen d'un procédé de CVD thermique sans excitation au plasma supplémentaire, dotée d'une teneur en halogène < 1 at% et d'une teneur en oxygène < 4 at%, qui contient une phase nanocristalline de TiCₓN₁₋ₓ avec 0,1 ≤ x ≤ 0,99 dotée d'une taille de cristallite entre 5 nm et 150 nm et une deuxième phase de SiCₓN_{y} amorphe avec 0,1 ≤ x ≤ 0,95 et 0,05 ≤ y ≤ 0,9.

2. Corps revêtus d'une substance dure selon la revendication 1, **caractérisé en ce que** la phase nanocristalline de TiCₓN₁₋ₓ est contenue en une proportion de 60 % en masse à 99 % en masse et la phase de SiCₓN_{y} amorphe est contenue en une proportion de 1 % en masse à 40 % en masse.

3. Corps revêtus d'une substance dure selon la revendication 1, **caractérisé en ce que** la teneur en carbone de la couche de composite de TiSiCN est supérieure à 8 at%.

4. Corps revêtus d'une substance dure selon la revendication 1, **caractérisé en ce que** la couche de nanocomposite de TiSiCN contient jusqu'à 5 % en masse de carbone amorphe en tant qu'ingrédient supplémentaire.

5. Corps revêtus d'une substance dure selon la revendication 1, **caractérisé en ce que** la couche de nanocomposite de TiSiCN est constituée de couches individuelles de TiSiCN comportant différents rapports titane/silicium.

6. Corps revêtus d'une substance dure selon la revendication 1, **caractérisé en ce que** la couche de nanocomposite de TiSiCN présente un gradient en ce qui concerne la teneur en silicium et en titane.

7. Corps revêtus d'une substance dure selon la revendication 1, **caractérisé en ce que** la couche de nanocomposite de TiSiCN est combinée au corps de substrat, dans un système de couches multicouche, comportant une ou plusieurs couches de couverture et/ou couches de liaison, ces couches étant constituées d'un ou plusieurs nitrures, carbures, carbonitrures, oxynitrures, oxycarbures, oxycarbonitrures, oxydes de Ti, Hf, Zr, Cr et/ou Al ou de phases mixtes avec ces éléments.

8. Procédé pour la préparation de corps revêtus d'une substance dure composés de métal, de métal dur, de cermet ou de céramique, revêtus avec une couche de composite de TiSiCN ou avec un système de couches multicouche, qui contient au moins une couche de composite de TiSiCN, la couche de composite de TiSiCN étant une couche de nanocomposite dotée d'une teneur en halogène < 1 at% et d'une teneur en oxygène < 4 at%, qui contient une phase nanocristalline de TiCₓN₁₋ₓ avec 0,1 ≤ x ≤ 0,99 dotée d'une taille de cristallite entre 5 nm et 150 nm et une deuxième phase de SiCₓN_{y} amorphe avec 0,1 ≤ x ≤ 0,95 et 0,05 ≤ y ≤ 0,9, selon la revendication 1, **caractérisé en ce que** la couche de nanocomposite de TiSiCN est déposée sur le corps dans un mélange de gaz qui contient un ou plusieurs halogénures de titane, SiCl₄ ou Si₂Cl₆, de l'hydrogène ainsi que de l'acétonitrile en tant que composé réactif avec des atomes de carbone et d'azote, avec un procédé de CVD thermique à des températures comprises entre 700 °C et 1 100 °C et à des pressions comprises entre 10 Pa et 101,3 kPa sans excitation au plasma supplémentaire, le rapport molaire des halogénures de titane et des précurseurs contenant du silicium étant choisi de telle sorte qu'un rapport atomique de Si sur Ti soit plus grand que 1 dans le mélange de gaz.

9. Procédé selon la revendication 8, **caractérisé en ce que** des composés azotés et/ou des hydrocarbures et/ou des gaz nobles inertes sont de plus ajoutés au mélange de gaz.

10. Procédé selon la revendication 9, **caractérisé en ce qu'en** tant que composés azotés, N₂ et/ou NH₃ sont utilisés et en tant qu'hydrocarbures, C₂H₄ et/ou C₂H₂ sont utilisés.
